# EUROPEAN PATENT SPECIFICATION

(11) **EP 2 309 039 B1**
(45) Date of publication and mention of the grant of the patent: **01.04.2015**
(21) Application number: 09773287.9
(22) Date of filing: 12.06.2009
(51) Int. Cl.: C30B 29/36

(54) **SEED CRYSTAL FOR GROWTH OF SILICON CARBIDE SINGLE CRYSTAL, PROCESS FOR PRODUCING THE SAME, AND PROCESS FOR PRODUCING SILICON CARBIDE SINGLE CRYSTAL BY SUBLIMATION**
KEIMKRISTALL ZUM ZÜCHTEN VON SILICIUMCARBIDEINKRISTALL, VERFAHREN ZU SEINER HERSTELLUNG UND VERFAHREN ZUR HERSTELLUNG VON SILICIUMCARBIDEINKRISTALL DURCH SUBLIMATION
GERME CRISTALLIN POUR LA CROISSANCE D'UN MONOCRISTAL DE CARBURE DE SILICIUM, PROCÉDÉ POUR LE PRODUIRE, ET PROCÉDÉ DE FABRICATION D' UN MONOCRISTAL DE CARBURE DE SILICIUM PAR SUBLIMATION

(30) Priority: 04.07.2008 JP 2008176255
(43) Date of publication of application: 13.04.2011
(73) Proprietor: Showa Denko K.K., Tokyo 105-8518 (JP)
(72) Inventor: OYANAGI Naoki, Chichibu-shi Saitama 369-1893 (JP); KOGOI Hisao, Chichibu-shi Saitama 369-1893 (JP)
(74) Representative: Strehl Schübel-Hopf & Partner
(86) International application number: PCT/JP2009/060788
(87) International publication number: WO 2010/001709

(56) References cited:
- WO-A2-2006/041660
- DE-A1- 19 644 153
- GB-A- 2 086 943
- JP-A- 1 046 221
- JP-A- 9 268 096
- JP-A- 11 189 433
- JP-A- 60 174 873
- JP-A- 2002 201 097
- JP-A- 2003 137 694
- US-A- 5 944 890
- US-A1- 2002 083 892
- ROBERTSON ET AL: "Properties of diamond-like carbon", SURFACE AND COATINGS TECHNOLOGY, ELSEVIER, AMSTERDAM, NL, vol. 50, no. 3, 6 February 1992 (1992-02-06), pages 185-203, XP025702053, ISSN: 0257-8972, DOI: 10.1016/0257-8972(92)90001-Q [retrieved on 1992-02-06]
- K.S. S ree H arsha: "PRINCIPLES OF PHYSICALVAPOR DEPOSITION OFTHIN FILMS", 1 January 2006 (2006-01-01), REFEREX, Great Britain, XP040425595, ISBN: 978-0-08-044699-8 * page 611, paragraph 2 *

## Description

### Technical Field

The present invention relates to a seed crystal for silicon carbide single crystal growth, a method for producing the seed crystal, and a method for producing the single crystal.

The present patent application claims priority from Japanese Patent Application No. 2008-176255 filed on July 4, 2008, the disclosure of which is incorporated herein by reference.

### Background Art

Silicon carbide is a material having high thermal conductivity. Silicon carbide is also physically and chemically stable, has excellent thermal resistance and mechanical strength, and has high radiation resistance. Accordingly, silicon carbide is used as a material for rectifying elements or switching elements with high pressure resistance and low loss. Furthermore, silicon carbide has a broad energy band gap (forbidden band width), and a 4H type silicon carbide single crystal in particular has a forbidden band width of about 3 eV at room temperature. The characteristics described above allow silicon carbide to be used as a material for environment-resistant elements or radiation-resistant elements that can be used at high temperatures, and the like.

As a method for producing a silicon carbide single crystal, use is usually made of a sublimation method of subliming a silicon carbide powder as a raw material at a high temperature (see, for example, PTL 1).

In the method for producing a silicon carbide single crystal according to the sublimation method, a crucible filled with a raw material silicon carbide powder and having a substrate for a seed crystal formed of silicon carbide installed therein is subjected to pressure reduction in an inert gas atmosphere, and the entire apparatus is heated to 1800°C to 2400°C. As the silicon carbide powder undergoes decomposition and sublimation under heating, a gas generated therefrom (sublimated chemical species) reaches the surface of the substrate for the seed crystal that has been held in the growth temperature region, and epitaxially grows into a single crystal.

Using to this method, even wafers having a diameter of about 3 inches are commercially available at present.

In the sublimation method, the raw material silicon carbide is maintained at a high temperature exceeding 2000°C, and thereby gases of Si, Si₂C, SiC₂, SiC and the like (sublimated chemical species) are generated. On the other hand, a seed crystal is disposed at a position inside the crucible, where the temperature is lower than the temperature of the raw material silicon carbide by about 50°C to 200°C. Thereby, these gases (sublimated chemical species) are deposited on the seed crystal formed of silicon carbide, and a silicon carbide single crystal is thus grown.

In this situation, a portion of the seed crystal formed of silicon carbide may be locally maintained at a high temperature of about 2000°C or higher, and that portion sublimates and generates a sublimation gas. This may cause the occurrence of in-crystal cavity defects such as micropipes.

Furthermore, the seed crystal formed of silicon carbide is generally attached to a member formed of graphite with an adhesive or the like. However, the adhesive between the graphite and seed crystal vaporizes at a high temperature around 2000°C and thereby generates an impurity gas or the like. A sublimation gas is generated in relation to the impurity gas. This may cause the occurrence of the in-crystal cavity defects such as micropipes.

As a method for suppressing the occurrence of crystal defects due to such sublimation of a seed crystal, there is available, for example, a method of providing a gas barrier to the sublimation gas generated as a result of sublimation on the interface side of the seed crystal by providing a protective film on the rear side of the seed crystal (between graphite and the seed crystal), and thereby suppressing the sublimation of the seed crystal while suppressing the occurrence of crystal defects.

PTL 1 is related to a method for producing a single crystal and to a seed crystal, and discloses that when the surface other than the surface where the single crystal grows is coated with a carbon layer (protective film) or the like, the local temperature gradient is moderated, and also recrystallization is suppressed, so that the quality of the growing crystal is enhanced.

However, in the carbon protective film that is formed by carbonization (carbonization process) of SiC, which is mainly recommended in the PTL 1, Si-based volatile matter is generated at high temperatures so that the carbon protective film is prone to becoming porous, and sufficient gas barrier properties that are required to suppress the sublimation of the seed crystal cannot be obtained. Accordingly, it is difficult to maintain the air-tightness at the contact parts between the graphite and the seed crystal, and crystal defects due to the sublimation are noticeably generated on the interface side of the seed crystal.

Furthermore, PTL 1 also discloses that the protective film may be formed as a metal film of tantalum or the like, but when such a metal film is exposed to a high temperature environment and is between graphite and a seed crystal, the metal film consequently changes into a carbide and thereby undergoes a change in volume. Thus, cracks occur in the metal film and cause a problem with adhesiveness. Therefore, the gas barrier properties of the metal film are decreased, and the effect of suppressing the sublimation of seed crystals is reduced.

Moreover, although PTL 1 also discloses that the protective film may be formed of a carbide of a metal such as tantalum (metal compound), since the metal compound has a large difference in thermal expansion compared with graphite, thermal stresses occur attributable to the difference in thermal expansion in a high temperature environment, and cracks occur in the protective film, causing a problem with adhesiveness. Accordingly, the gas barrier properties of the protective film are decreased, and the effect of suppressing the sublimation of seed crystals is reduced.

PTL 2 relates to a seed crystal for silicon carbide single crystal growth, a silicon carbide single crystal ingot, and a method for producing these, and it is disclosed that when an organic thin film having a thickness in a predetermined range is formed on the rear surface of the surface where the seed crystal grows, a high quality silicon carbide single crystal ingot having far fewer structural results, is obtained.

However, as shown in PTL 2, in the case of obtaining a protective film by carbonizing an organic thin film, when the organic thin film is carbonized, the organic thin film itself is thermally decomposed and generates a hydrocarbon-based decomposition product gas such as methane or ethylene. This decomposition product gas makes the protective film porous and lowers the gas barrier properties. Thereby, the effect of suppressing the sublimation of seed crystals is reduced.

[PTL 1] Japanese Unexamined Patent Application Publication No. 9-268096
[PTL 2] Japanese Unexamined Patent Application Publication No. 2003-226600

US 2002/083892 A1 discloses a seed crystal for silicon carbide single crystal growth, which is attached to a lid of a graphite crucible charged with a raw material silicon carbide powder, wherein the seed crystal comprises a seed crystal formed of silicon carbide having one surface defined as a growth surface for growing a silicon carbide single crystal by a sublimation method, and a high density carbon film formed on the surface opposite to the growth surface.

US 5 944 890 A discloses a silicon carbide single crystal having a micropipe density of 2 micropipes/cm² or less.

Robertson et al. : "Properties of diamond-like carbon", Surface and Coatings Technology, Elsevier, Amsterdam, NL, vol. 50, no. 3, 6 February 1992, pages 185 to 203 discloses a seed crystal for silicon carbide single crystal growth, wherein a carbon film formed on the surface of the seed crystal is a non-crystalline film.

WO 2006/041660 A2 discloses a silicon carbide single crystal having a micropipe density of 7 micropipes/cm² or less.

K. S. Sree Harsha: "Principles of physical vapor deposition of thin films", 1 January 2006, REFEREX, XP040425595, page 611 and DE 196 44 153 A1 disclose a method for producing a silicon carbide single crystal, wherein the bombardment of the surface by energetic particles before deposition of the film is utilized to clean the surface, so that adsorbed molecules can be desorbed from the surface of the substrate.

JP 60 174873 A discloses cleaning the surface of a metallic substrate for vapour deposition by impressing a high frequency electric field to a gaseous mixture obtained by adding a very small amount of gaseous hydrogen to an inert gas and by utilizing generated plasma for subjecting the substrate to ion bombardment.

GB 2 086 943 A discloses cleaning the surface of a tool before vapour deposition by impressing a high frequency electric field to a gaseous mixture obtained by adding a small amount of gaseous hydrogen to an inert gas and by utilizing generated plasma for subjecting the substrate to ion bombardment.

### Summary of Invention

### Technical Problem

The present invention was made under such circumstances, and thus it is an object of the present invention to provide a seed crystal for silicon carbide single crystal growth, which is capable of suppressing crystal defects that arise from the interface between the seed crystal and graphite, and producing a high quality silicon carbide single crystal having a low crystal defect density with good reproducibility.

### Solution to Problem

The present inventors made a thorough investigation of the carbon films that are formed at the rear surface of seed crystals. As a result, they found that when an attempt is made to carbonize a silicon carbide or hydrocarbon film (carbonization process), a decomposition product gas is generated as a result of the carbonization, and thereby the carbon film becomes porous, so that the gas transmission is increased and consequently the gas barrier properties are decreased.

Based on this, the inventors conceived a constitution in which the occurrence of crystal defects due to the sublimation of seed crystals is suppressed, without using the carbonization process such as described above, by directly forming a dense carbon film having low gas transmission on the surface of a silicon carbide substrate on the rear surface of the seed crystal with a high adhesive strength.

Thus, in order to achieve the object described above, the invention employs the following constitution.
[1] A seed crystal for silicon carbide single crystal growth, which is attached to a lid of a graphite crucible charged with a raw material silicon carbide powder,
   wherein the seed crystal comprises a seed crystal formed of silicon carbide having one surface defined as a growth surface for growing a silicon carbide single crystal by a sublimation method, and a carbon film formed on the surface opposite to the growth surface;
   the film density of the carbon film is 1.8 g/cm³ to 2.5 g/cm³; and
   the thickness of the carbon film is equal to or greater than 0.1 µm and equal to or less than 20 µm.
[2] The seed crystal for silicon carbide single crystal growth according to [1] above, wherein the carbon film is a non-crystalline film.
[3] A method for producing a seed crystal for silicon carbide single crystal growth, which is a method for producing the seed crystal for silicon carbide single crystal growth according to [1] or [2] above, the method comprising:
   a carbon film forming step of forming a carbon film having a film density of 1.8 g/cm³ to 2.5 g/cm³ by a physical vapor deposition method or a chemical vapor deposition method, on one surface of the seed crystal formed of silicon carbide.
[4] The method for producing a seed crystal for silicon carbide single crystal growth according to [3] above, wherein the carbon film is formed by any one of a sputtering method, an ion beam method and a plasma CVD method.
[5] The method for producing a seed crystal for silicon carbide single crystal growth according to [4] above, wherein reverse sputtering is carried out before the sputtering method.
[6] The method for producing a seed crystal for silicon carbide single crystal growth according to [5] above, wherein the reverse sputtering is carried out using an inert gas with added hydrogen gas or oxygen gas.
[7] The method for producing a seed crystal for silicon carbide single crystal growth according to [6] above, wherein the hydrogen gas or the oxygen gas in the inert gas is contained at a concentration of 10% or greater.
[8] A method for producing a silicon carbide single crystal, the method comprising:
   attaching, with the use of an adhesive, the seed crystal for silicon carbide single crystal growth according to [1] or [2] above, to the lid of a graphite crucible charged with a raw material silicon carbide powder; and
   heating the graphite crucible to sublimate the raw material silicon carbide powder and to thereby carry out the crystal growth of a silicon carbide single crystal on the seed crystal for silicon carbide single crystal growth.

### Advantageous Effects of Invention

According to the constitution described above, there can be provided a seed crystal for silicon carbide single crystal growth which is capable of suppressing crystal defects that arise from the interface between the seed crystal and the graphite, and producing a high quality silicon carbide single crystal having a low crystal defect density, with high reproducibility.

The seed crystal for silicon carbide single crystal growth of the invention has a constitution in which the seed crystal has a seed crystal formed of silicon carbide and having one surface defined as a growth surface for growing a silicon carbide single crystal by a sublimation method, and a carbon film formed on the surface of the opposite side of the growth surface of the seed crystal, wherein the film density of the carbon film is 1.8 g/cm³ to 2.5 g/cm³. Therefore, by increasing the strength of the carbon film, the carbon film can be made into a sufficiently hard film, and at the same time, can be made into a dense film having excellent gas barrier properties. The carbon film is preferably a non-crystalline carbon film having excellent gas barrier properties and having high adhesiveness to silicon carbide. Examples of the non-crystalline carbon film include a carbon film called DLC (diamond-like carbon) or a carbon film called glassy carbon, depending on the bonding state of carbon, but all of these have excellent gas barrier properties and high adhesiveness to silicon carbide due to their non-crystallinity. The representative density is such that the density of the DLC is about 1.8 g/cm³ to 2.5 g/cm³, and the density of the glassy carbon is about 1.8 g/cm³ to 2.5 g/cm³. By providing this dense protective film having high gas barrier properties and having high adhesiveness to silicon carbide on the rear surface of a seed crystal, crystal defects that arise from the interface between the seed crystal and graphite are suppressed, and a high quality silicon carbide single crystal having a low crystal defect density can be produced with good reproducibility.

The method for producing a seed crystal for silicon carbide single crystal growth of the invention has a constitution in which the carbon film is formed by any one of a sputtering method, an ion beam method, and a plasma CVD method. Therefore, the method can be used to form a dense carbon film having excellent uniformity and excellent gas barrier properties, can be used to suppress crystal defects that arise from the interface between the seed crystal and the graphite, and can be used to produce a high quality silicon carbide single crystal having a low crystal defect density and having high reproducibility.

The method for producing a silicon carbide single crystal of the invention has a constitution in which the seed crystal for silicon carbide single crystal growth according to item 1 or 2 is attached to the lid of a graphite crucible charged with a raw material silicon carbide powder, the graphite crucible is heated to sublimate the raw material silicon carbide powder, and thereby crystal growth of a silicon carbide single crystal is achieved on the seed crystal for silicon carbide single crystal growth. Therefore, a dense carbon film having excellent uniformity, having excellent gas barrier properties and having high adhesiveness to silicon carbide can be formed, crystal defects that arise from the interface between the seed crystal and the graphite can be suppressed, and a high quality silicon carbide single crystal having a low crystal defect density can be produced with good reproducibility.

The method for producing a silicon carbide single crystal of the invention has a constitution in which the silicon carbide single crystal is formed using the method for producing a silicon carbide single crystal described above, and has a micropipe density of 10 micropipes/cm² or less. Therefore, a dense carbon film having excellent uniformity, having excellent gas barrier properties and having high adhesiveness to silicon carbide can be formed, crystal defects that arise from the interface between the seed crystal and the graphite can be suppressed, and a high quality silicon carbide single crystal having a low crystal defect density can be produced with good reproducibility.

### Brief Description of Drawings

FIG. 1 is a cross-sectional view showing an example of a crystal growing apparatus provided with the seed crystal for silicon carbide single crystal growth of the invention.
FIG. 2 is a partial magnified view of the part of the seed crystal for silicon carbide single crystal growth of the invention attached to the graphite crucible.
FIG. 3 is a cross-sectional photograph showing the boundary part between the seed crystal and the silicon carbide single crystal, and FIG. 3(a) shows a case of using the seed crystal for silicon carbide single crystal growth of the invention having a carbon film formed thereon, while FIG. 3(b) shows a case of using a seed crystal formed of silicon carbide, which does not have a carbon film foamed thereon.

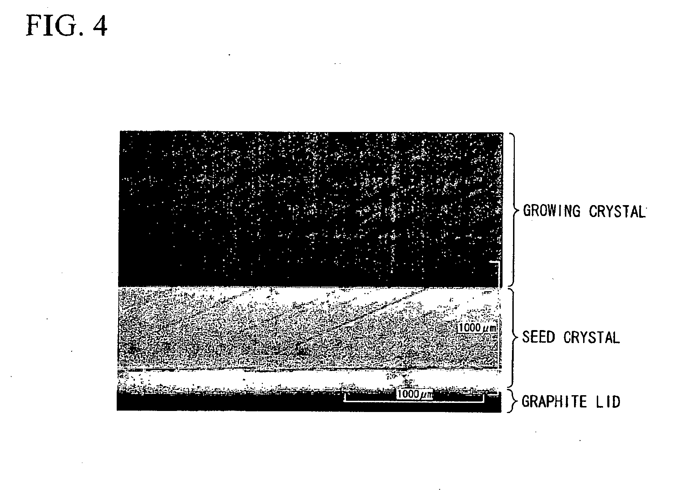

FIG 4 is a cross-sectional photograph of a case of using the seed crystal for silicon carbide single crystal of the invention having a carbon film formed thereon.

### Description of Embodiments

Hereinafter, embodiments for carrying out the invention will be described.

### (Embodiment 1)

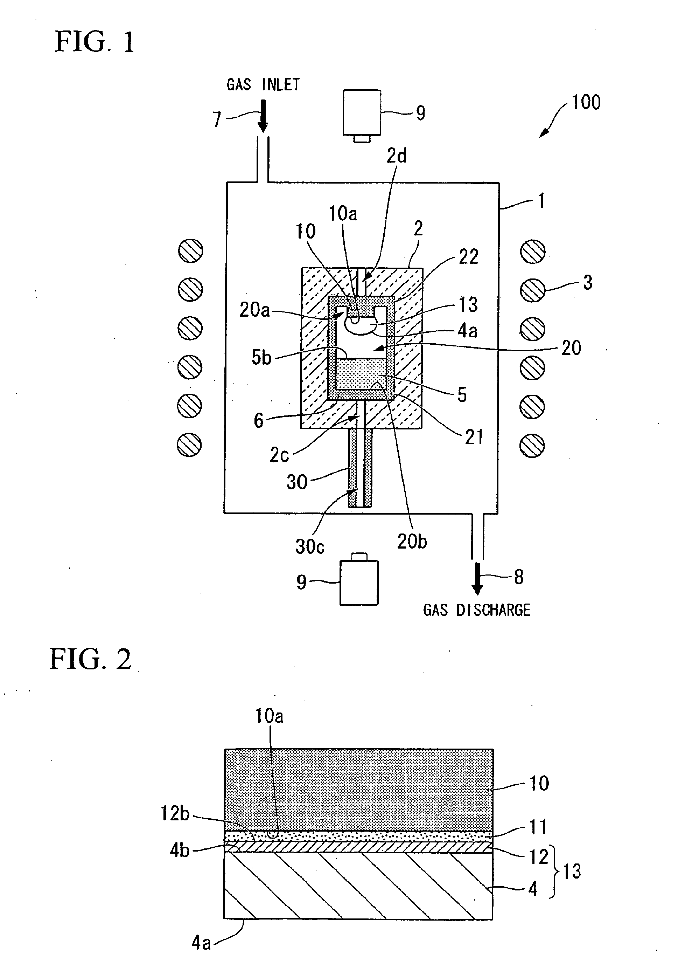

FIG. 1 is a diagram intended to explain an example of the seed crystal for silicon carbide single crystal growth, which is an embodiment of the invention, and is a schematic cross-sectional view showing an example of a crystal growing apparatus equipped with the seed crystal for silicon carbide single crystal growth which is an embodiment of the invention.

As shown in FIG 1, the crystal growing apparatus 100 is approximately constructed to have a graphite crucible 6 covered with a thermally insulating material 2 disposed inside a vacuum container 1. The graphite crucible 6 includes a lid 22 and a body portion 21. In addition a seed crystal for silicon carbide single crystal growth 13, which is an embodiment of the invention, is bonded to one surface 10a of the protruded part 10 of the lid 22 of the graphite crucible 6.

As the material for the vacuum container 1, it is preferable to use a material that can maintain a high vacuum, and examples of the material include quartz and stainless steel.

Furthermore, as the material for the graphite crucible 6 and the thermally insulating material 2, it is preferable to use a material that is stable at high temperature and generates less impurity gas, and an example of the material may be a carbon material that has been subjected to a purification treatment using a halogen gas.

The graphite crucible 6 includes the lid 22 and the body portion 21, and has a cavity portion 20 inside the body portion 21. In the upper part of the inside of the cavity portion 20, the seed crystal for silicon carbide single crystal growth 13 is fixed. Furthermore, in the lower part of the inside of the cavity portion 20, a raw material silicon carbide powder 5 is placed in an amount sufficient for the crystal growth of a silicon carbide single crystal on the seed crystal for silicon carbide single crystal growth 13.

The cavity portion 20 has a sufficient amount of the raw material silicon carbide in the lower part of the inside, and also has the space necessary for the crystal growth of a silicon carbide single crystal, secured in the upper part of the inside. Accordingly, crystal growth of a silicon carbide single crystal can be achieved on the growth surface 4a of the seed crystal for silicon carbide single crystal growth 13 toward the inner bottom surface 20 side, according to a sublimation method.

A heating coil 3 is wound around the vacuum container 1. This allows heating of the vacuum container 1, and also, the crystal growing apparatus has a configuration capable of heating the graphite crucible 6.

The vacuum container 1 has a configuration in which air is discharged through a vacuum pump (not depicted) connected to a discharge pipe 8, and thus the inside of the vacuum container 1 can be depressurized. The vacuum container 1 also has a configuration in which any gas can be supplied to the inside of the vacuum container 1 through an inlet pipe 7.

For example, after the vacuum container is brought to a depressurized state by discharging the air inside the container through the discharge pipe 8, high purity argon (Ar) gas is supplied to the inside of the vacuum container 1 through the inlet pipe 7, and the vacuum container is brought again to a depressurized state. Thereby, the inside of the vacuum container 1 can be brought into a depressurized state with an argon (Ar) atmosphere.

On the outside of the graphite crucible 6, a heating coil 3 is installed so as to surround the graphite crucible 6. This heating coil 3 is a high frequency heating coil, and is capable of heating the vacuum container 1 to a temperature of, for example, 1900°C or higher, by generating a high frequency by flowing an electric current.

Thereby, the graphite crucible 6 installed at the center inside the vacuum container 1 is heated, and thereby the raw material silicon carbide powder 5 inside the graphite crucible 6 is heated, so that a sublimated gas is generated from the raw material silicon carbide powder 5.

In addition, a resistance heating type coil may be used as the heating coil 3.

As shown in FIG. 1, a protruded part 10 is provided on one surface of the lid 22. When the body portion 21 is covered by the lid 22, the protruded part 10 forms a conical-shaped protruded part which protrudes from the lid 22 toward the inner bottom surface 20b side. Furthermore, the protruded part 10 has one surface 10a intended to have the seed crystal for silicon carbide single crystal growth 13 disposed thereon, on the side of the inner bottom surface 20b.

FIG. 2 is a schematic cross-sectional view explaining an example of the disposition of the seed crystal for silicon carbide single crystal growth which is an embodiment of the invention.

As shown in FIG. 2, the seed crystal for silicon carbide single crystal growth 13 has a seed crystal 4 formed of silicon carbide and a carbon film 12, and one surface of the seed crystal 4 formed of silicon carbide is used as a growth surface 4a for the crystal growth of a silicon carbide single crystal, while the carbon film 12 is formed on the surface 4b on the opposite side of the growth surface.

The surface 12b of the carbon film 12 on the opposite side of the seed crystal 4 formed of silicon carbide serves as a bonding surface 12b which can be attached, with an adhesive 11, to the one surface 10a of the protruded part 10 formed of a graphite member.

### (Seed crystal)

As the seed crystal 4 formed of silicon carbide, a single crystal formed of silicon carbide (silicon carbide single crystal) is used. As this silicon carbide single crystal, a product obtained by cutting a cylindrical-shaped silicon carbide single crystal produced by an Acheson method, a Lely method, a sublimation method or the like, in the transverse direction to a thickness of about 0.3 to 2 mm into a disk shape, and then shaping the single crystal by polishing the cut surface, is used. Furthermore, in order to remove any polishing damage after this polishing as a final finish of the seed crystal for silicon carbide single crystal growth 4, it is preferable to perform sacrificial oxidation, reactive ion etching, chemical-mechanical polishing or the like. In addition, subsequently the surface of the seed crystal 4 formed of silicon carbide is cleaned using an organic solvent, an acidic solution, an alkali solution or the like.

### (Carbon film)

The bonding surface 4b of the seed crystal 4 formed of silicon carbide has the carbon film 12 formed thereon.

The carbon film 12 is preferably a non-crystalline film. Thereby, a dense film having excellent uniformity, having excellent gas barrier properties, and having high adhesiveness to silicon carbide can be obtained. In addition, it can be determined whether the carbon film 12 is non-crystalline or not, by measuring the X-ray diffraction of the carbon film 12.

Examples of the non-crystalline carbon film 12 include a glassy carbon film and a diamond-like carbon film. Both of the films result in dense carbon films having excellent uniformity, having excellent gas barrier properties, and having high adhesiveness to silicon carbide.

The film density of the carbon film is 1.8 g/cm³ to 2.5 g/cm³. Thereby, the strength of the carbon film can be increased, and a sufficiently hard film can be obtained, while at the same time, a dense film having excellent gas barrier properties can be obtained. If the film density of the carbon film is less than 1.2 g/cm³, the denseness is insufficient, and the gas barrier properties are also poor. On the contrary, if the film density of the carbon film is greater than 3.3 g/cm³, the strength of the carbon film is insufficient, and for example, when heated, the carbon film has a problem that peeling of the carbon film from the silicon carbide crystal is prone to occur, which is not preferable.

In addition, the film density of the carbon film 12 can be adjusted by regulating the pressure of the gas atmosphere during the film formation. Furthermore, the film density of the carbon film 12 can be measured by using an X-ray reflection ratio analysis method.

There are no particular limitations on the thickness of the carbon film 12, if the film thickness is a thickness capable of suppressing the sublimation of the seed crystal 4 formed of silicon carbide, but the film thickness is equal to or greater than 0.1 µm and equal to or less than 20 µm.

If the thickness of the carbon film 12 is excessively small, there may be occasions in which the sublimation of the seed crystal 4 formed of silicon carbide cannot be suppressed, which is not preferable. For example, when the thickness of the carbon film 12 is less than 0.1 µm, it is difficult to obtain a uniform film over the entire surface of the other surface 4b of the seed crystal 4 formed of silicon carbide, and the sublimation of the seed crystal 4 formed of silicon carbide may occur through the part with a small thickness. On the contrary, if the thickness of the carbon film 12 is greater than 100 µm, the rate of film formation is slowed, and therefore, the productivity is extremely deteriorated, which is not preferable. By limiting the thickness of the carbon film 12 to be equal to or greater than 0.1 µm and equal to or less than 20 µm, the sublimation of the seed crystal 4 formed of silicon carbide can be suppressed, and the strength and adhesive strength of the carbon film 12 can be maintained in a more stable manner.

Next, the method for producing a seed crystal for silicon carbide single crystal growth, which is an embodiment of the invention, will be described below.

The method for producing a seed crystal for silicon carbide single crystal growth, which is an embodiment of the invention, has a carbon film forming step of forming a carbon film having a film density of 1.8 g/cm³ to 2.5 g/cm³ by a physical vapor deposition method or a chemical vapor deposition method, on the other surface 4b of the seed crystal 4 formed of silicon carbide.

### (Carbon film forming step)

Since the non-crystalline carbon film 12 is a hard film, it is necessary to form the carbon film 12 after increasing the adhesive strength of the carbon film 12 to the seed crystal 4 formed of silicon carbide, in order to maintain the adhesiveness at a high level so as to prevent the peeling of the carbon film 12 from the seed crystal 4 formed of silicon carbide under a high temperature environment of about 2000°C or higher.

Examples of the method for forming such a carbon film 12 that can be used include physical vapor deposition (PVD) methods such as a sputtering method, an ion beam method, a laser abrasion method, an ion plating method, and an electron beam deposition method; and chemical vapor deposition (CVD) methods such as a microwave CVD method, an RF plasma CVD method, a DC plasma CVD method, and a thermal filament CVD method.

From the viewpoint of easy performance of a surface treatment prior to the production by reverse sputtering for the purpose of enhancing the quality of the film, enhancing the cost aspects and enhancing the adhesive strength, a sputtering method is more preferable.

Particularly, in the case of forming a carbon film 12 formed from glassy carbon, a sputtering method is suitable. Furthermore, in the case of forming a carbon film 12 formed of diamond-like carbon, an ion beam method or a plasma CVD method is suitable.

### (Reverse sputtering)

In the case of forming a carbon film 12 by a sputtering method, it is preferable to perform reverse sputtering before the carbon film is formed by a sputtering method.

Reverse sputtering means that in a conventional sputtering method, sputtering is performed while reversing the magnitude of the voltage applied to the electrode on the target side and the electrode on the substrate side. Thereby, an inert gas that has been ionized by applying a high voltage is bombarded to the substrate, and thereby the substrate surface can be cleaned, or sputter etching can be carried out. Accordingly, when reverse sputtering is carried out, the properties of the surface of the seed crystal 4 are changed, and the adhesiveness to the carbon film 12 is increased. Then, the effect of protecting the seed crystal 4 formed of silicon carbide by the carbon film 12 can be maintained in a more stable manner.

The reverse sputtering is preferably carried out by using an inert gas such as Ar (argon) gas with added hydrogen gas or oxygen gas. When the reverse sputtering is carried out after adding hydrogen or oxygen gas to the inert gas, the adhesiveness between the carbon film 12 and the seed crystal 4 formed of silicon carbide can be further enhanced, and thus the effect of suppressing the occurrence of crystal defects can be enhanced.

The conditions for reverse sputtering are, for example, a temperature of 90°C to 120°C, an Ar gas pressure (pressure of Ar gas atmosphere) of 0.5 Pa, and a power of 40 kW to 60 kW.

The hydrogen gas or oxygen gas is preferably contained in the inert gas at a concentration of 10% or greater. According to the present embodiment, the hydrogen gas or oxygen gas is contained in the Ar (argon) gas at a concentration of 10% or greater. If the content is less than 10%, the effect of enhancing the adhesiveness between the carbon film 12 and the seed crystal 4 formed of silicon carbide is small, and the effect of suppressing the occurrence of crystal defects is not exhibited.

When a carbon film 12 having a film density of 1.2 g/cm³ to 3.3 g/cm³ is formed under the conditions described above, on the other surface 4b of the seed crystal 4 formed of silicon carbide, the carbon film can be made into a dense film having excellent uniformity and excellent gas barrier properties.

Next, the method for producing a silicon carbide single crystal, which is an embodiment of the invention, will be described.

The method for producing a silicon carbide single crystal, which is an embodiment of the invention, has a seed crystal attaching step and a crystal growing step.

### (Seed crystal attaching step)

The seed crystal attaching step is a step of attaching the seed crystal for silicon carbide single crystal growth, which is an embodiment of the invention, to the lid of a graphite crucible including a container body having a cavity communicating with an opening, and a lid for the opening.

The seed crystal for silicon carbide single crystal growth 13 is attached to the lid 22 by applying an adhesive 11 on the bonding surface 12b of the carbon film 12 formed on the surface 4b on the opposite side of the growth surface of the seed crystal 4 formed of silicon carbide, and attaching the seed crystal to the protruded part 10 formed of a graphite member. At this time, when the body portion 21 is provided with the lid 22, the seed crystal for silicon carbide single crystal growth 13 is attached to the lid 22 so that the growth surface 4a of the seed crystal faces the surface 5b on the opening side of the raw material silicon carbide powder 5. In addition, the (0001) Si surface or the (000-1) C surface is used as the growth surface 4a for growing a silicon carbide single crystal using a sublimation method, but the surface may be a surface that is obtainable by tilting the growth surface (crystal surface) 4a by about 30° from the {0001} Si surface.

Any adhesive that is generally used can be used as the adhesive 11, and examples thereof include a phenolic resin.

If the carbon film 12 is not provided, the adhesive 11 is thermally decomposed by the heating at the time of crystal growth and is carbonized, thereby forming a porous carbon layer. At this time, the sublimated gas generated at the rear surface of the silicon carbide seed crystal 4 escapes from the porous carbon layer, and thus various large and small cavities are formed from the rear surface side of the seed crystal.

However, when the carbon film 12 is provided, even if the adhesive 11 is converted to a porous carbon layer, the carbon film 12 having excellent gas barrier properties blocks the sublimated gas from the seed crystal, and there is no chance for cavities to be formed in the seed crystal 4 formed of silicon carbide. Accordingly, there is no chance for in-crystal cavity defects such as micropipes to be generated in the silicon carbide single crystal.

### (Crystal growing step)

The crystal growing step is a step of charging the cavity portion with a raw material silicon carbide powder, covering the opening with the lid, and then carrying out the crystal growth of a silicon carbide single crystal on the seed crystal for silicon carbide single crystal growth using the sublimated gas generated from the raw material silicon carbide powder, by heating the graphite crucible.

First, the raw material silicon carbide powder 5 is placed on the inner bottom surface 20b side of the cavity portion 20. At this time, the surface 5b on the opening side of the raw material silicon carbide powder is arranged to face the growth surface 4a of the seed crystal for silicon carbide single crystal growth 13 attached to the lid 22, when the lid 22 is covering the body portion 21.

Subsequently, the lid 22 with the attached seed crystal 4 formed of silicon carbide is placed on top of the body portion 21 such that the seed crystal for silicon carbide single crystal growth 13 is inserted into the cavity portion 20, and the lid 22 is made to cover the opening 20a.

Subsequently, a thermally insulating material 2 is wound around to cover the entirety of the graphite crucible 6 including the lid 22 with the attached seed crystal for silicon carbide single crystal growth 13 and the body portion 21 equipped with the lid 22. At this time, holes 2c and 2d are formed so that the lower surface and the upper surface of the graphite crucible 6 are partially exposed.

The thermally insulating material 2 is intended to maintain the graphite crucible 6 stably in a high temperature state, and for example, a material made of carbon fiber can be used. When the graphite crucible 6 can be maintained stably in a high temperature state to a necessary extent, the thermally insulating material 2 may not be attached.

Thereafter, the graphite crucible 6 wound with the thermally insulating material 2 is installed on a supporting rod 30 at the center inside the vacuum container 1.

The supporting rod 30 is in the form of a cylinder, and the hole 30c on this supporting rod 30 is superimposed with the hole 2c provided on the thermally insulating material 2. Thereby, a configuration is obtained such that the temperature at the lower surface of the graphite crucible 6 can be monitored by a radiation thermometer 9 disposed below the vacuum container 1, through this hole 30c of the supporting rod 30 and the hole 2c on the lower side of the thermally insulating material 2. Similarly, a configuration is obtained such that the temperature at the upper surface of the graphite crucible 6 can be monitored by another radiation thermometer 9 disposed above the vacuum container 1, through the hole 2d on the upper side of the thermally insulating material 2.

Subsequently, gas exchange inside the vacuum container 1 is implemented. First, the air inside the vacuum container 1 is discharged using a vacuum pump (not depicted) connected to a discharge pipe 8, and the vacuum container is brought to a depressurized state of a pressure of 4×10⁻³ Pa or less. As the vacuum pump, for example, a turbo molecular pump or the like can be used.

Thereafter, high purity Ar gas is sufficiently introduced into the inside of the vacuum container 1 through the inlet pipe 7, and the inside of the vacuum container 1 is brought under an environment of an Ar atmosphere at 9.3×10⁴ Pa.

Subsequently, while the inside of the vacuum container 1 is maintained under an environment of an Ar atmosphere at 9.3×10⁴ Pa, the vacuum container 1 is slowly heated using the heating coil 3, and thus the temperature inside the vacuum container 1 is slowly raised from room temperature to about 1800°C.

Thereafter, the temperature of the raw material silicon carbide powder 5 inside the graphite crucible 6 is adjusted to a temperature of 2000°C to 2400°C, which is the sublimation temperature, and thereby the crystal growth of a silicon carbide single crystal is initiated. This state is maintained for, for example, about 50 hours, and thereby the sublimation gas of Si, Si₂C, SiC₂, SiC and the like is slowly deposited on the growth surface 4a. Thus, a silicon carbide single crystal can be grown.

At this time, the temperature at the growth surface 4a of the seed crystal for silicon carbide single crystal growth 13 is adjusted to a temperature lower by 50°C to 200°C than the temperature of the raw material silicon carbide 5, that is, to 1800° to 2350°C. Thereby, the sublimation of the seed crystal 4 formed of silicon carbide can be suppressed.

As such, heating with a temperature gradient, such as keeping the temperature of the lower part higher than the upper part of the graphite crucible 6, is adjusted by regulating the position of the heating coil 3, the method of winding, the number of windings, and the like.

Thereafter, the vacuum container 1 is cooled to room temperature, and the silicon carbide single crystal is removed. Thereby, the occurrence of in-crystal cavity defects such as micropipes or plate-shaped cavity defects, which arise from the interface between the seed crystal and the graphite, is suppressed, and a high quality silicon carbide single crystal having a low crystal defect density can be produced with good reproducibility. For example, a silicon carbide single crystal having a micropipe density of 10 micropipes/cm² or less can be produced.

In addition, a silicon carbide single crystal with regulated electrical conductivity can also be formed, if necessary, by adding impurities such as nitrogen or aluminum during the crystal growth.

The seed crystal for silicon carbide single crystal growth 13, which is an embodiment of the invention, has a constitution in which the seed crystal including a seed crystal 4 formed of silicon carbide with one surface thereof serving as a growth surface 4a for growing the silicon carbide single crystal by a sublimation method, and a carbon film 12 formed on the surface 4b on the opposite side of the growth surface of the seed crystal 4, and the film density of the carbon film 12 is 1.8 g/cm³ to 2.5g/m³. Therefore, when the strength of the carbon film 12 is increased, a sufficiently hard film can be obtained, and at the same time, a dense film having excellent gas barrier properties and having high adhesiveness can be obtained. Thereby, the crystal defects that arise from the interface between the seed crystal and the graphite can be suppressed, and a high quality silicon carbide single crystal having a low crystal defect density can be produced with good reproducibility.

Since the seed crystal for silicon carbide single crystal growth 13, which is an embodiment of the invention, has a constitution in which the carbon film 12 is a non-crystalline film, the carbon film 12 can be made into a dense film having excellent uniformity, excellent gas barrier properties, and high adhesiveness. Thereby, the crystal defects arising from the interface between the seed crystal and the graphite can be suppressed, and a high quality silicon carbide single crystal having a low crystal defect density can be produced with good reproducibility.

Since the seed crystal for silicon carbide single crystal growth 13, which is an embodiment of the invention, has a constitution in which the thickness of the carbon film 12 is equal to or greater than 0.1 µm and equal to or less than 20 µm the sublimation of the seed crystal 4 formed of silicon carbide can be suppressed. Thereby, the crystal defects arising from the interface between the seed crystal and the graphite can be suppressed, and a high quality silicon carbide single crystal having a low crystal defect density can be produced with good reproducibility.

Since the seed crystal for silicon carbide single crystal growth 13, which is an embodiment of the invention, has a constitution in which the thickness of the carbon film 12 is equal to or greater than 0.1 µm and equal to or less than 20 µm, the sublimation of the seed crystal 4 formed of silicon carbide can be suppressed, and at the same time, the strength and adhesive strength of the carbon film 12 can be maintained at a higher level in a stable manner. Thereby, the crystal defects arising from the interface between the seed crystal and the graphite can be suppressed, and a high quality silicon carbide single crystal having a low crystal defect density can be produced with good reproducibility.

Since the method for producing the seed crystal for silicon carbide single crystal growth 13, which is an embodiment of the invention, includes a carbon film forming step of forming a carbon film 12 having a film density of 1.8 g/cm³ to 2.5 g/cm³ by a physical vapor deposition method or a chemical vapor deposition method on one surface 4b of the seed crystal 4 formed of silicon carbide; a dense carbon film 12 having excellent uniformity, excellent gas barrier properties and high adhesiveness can be formed; the crystal defects arising from the interface between the seed crystal and the graphite can be suppressed; and a high quality silicon carbide single crystal having a low crystal defect density can be produced with good reproducibility.

Since the method for producing the seed crystal for silicon carbide single crystal growth 13, which is an embodiment of the invention, has a constitution in which the carbon film 12 is formed by any one of a sputtering method, an ion beam method and a plasma CVD method, a dense carbon film 12 having excellent uniformity, excellent gas barrier properties and high adhesiveness can be formed, the crystal defects arising from the interface between the seed crystal and the graphite can be suppressed, and a high quality silicon carbide single crystal having a low crystal defect density can be produced with good reproducibility.

Since the method for producing the seed crystal for silicon carbide single crystal growth 13, which is an embodiment of the invention, has a constitution in which reverse sputtering is carried out before the sputtering method is carried out, a dense carbon film 12 having excellent uniformity, excellent gas barrier properties and high adhesiveness can be formed, the crystal defects arising from the interface between the seed crystal and the graphite can be suppressed, and a high quality silicon carbide single crystal having a low crystal defect density can be produced with good reproducibility.

Since the method for producing the seed crystal for silicon carbide single crystal growth 13, which is an embodiment of the invention, has a constitution in which the reverse sputtering is carried out using an inert gas with hydrogen gas or oxygen gas added, a dense carbon film 12 having excellent uniformity, excellent gas barrier properties and high adhesiveness can be formed, the crystal defects arising from the interface between the seed crystal and the graphite can be suppressed, and a high quality silicon carbide single crystal having a low crystal defect density can be produced with good reproducibility.

Since the method for producing the seed crystal for silicon carbide single crystal growth 13, which is an embodiment of the invention, has a constitution in which the hydrogen gas or the oxygen gas in the inert gas is at a concentration of 10% or greater, a dense carbon film 12 having excellent uniformity, excellent gas barrier properties and high adhesiveness can be formed, the crystal defects arising from the interface between the seed crystal and the graphite can be suppressed, and a high quality silicon carbide single crystal having a low crystal defect density can be produced with good reproducibility.

Since the method for producing a silicon carbide single crystal, which is an embodiment of the invention, has a constitution in which the seed crystal for silicon carbide single crystal growth 13 is first attached to the lid 22 of the graphite crucible 6 charged with the raw material silicon carbide powder 5, the graphite crucible 6 is heated to sublimate the raw material silicon carbide powder 5, and thereby crystal growth of the silicon carbide single crystal is carried out on the seed crystal for silicon carbide single crystal growth 13, a dense carbon film 12 having excellent uniformity, excellent gas barrier properties and high adhesiveness can be formed, the crystal defects arising from the interface between the seed crystal and the graphite can be suppressed, and a high quality silicon carbide single crystal having a low crystal defect density can be produced with good reproducibility.

Since the method for producing a silicon carbide single crystal, which is an embodiment of the invention, has a constitution in which the silicon carbide single crystal is first formed by using the method for producing a silicon carbide single crystal described above, and the micropipe density is 10 micropipes/cm² or less, a dense carbon film 12 having excellent uniformity, excellent gas barrier properties and high adhesiveness can be formed, the crystal defects arising from the interface between the seed crystal and the graphite can be suppressed, and a high quality silicon carbide single crystal having a low crystal defect density can be produced with good reproducibility.

Hereinafter, the invention will be specifically described based on Examples.

### [EXAMPLES]

### (Example 1)

First, a silicon carbide seed crystal substrate formed from a 4H-silicon carbide single crystal having a substrate area of about 1.5 cm² and a thickness of 0.3 mm was provided, and this was subjected to washing with a sulfuric acid-hydrogen peroxide mixed solution at 110°C for 10 minutes, to water washing with flowing ultrapure water for 5 minutes, to washing with an ammonia-hydrogen peroxide mixed solution for 10 minutes, to water washing with flowing ultrapure water for 5 minutes, to washing with a hydrochloric acid-hydrogen peroxide for 10 minutes, to water washing with flowing ultrapure water for 5 minutes, and to washing with a HF solution. Subsequently, the surface was oxidized at 1200°C, and then the surface was subjected again to HF washing.

Subsequently, a carbon film was formed on the (000-1) surface of this seed crystal substrate, and thus a seed crystal for silicon carbide single crystal growth was formed. A direct current discharge sputtering method was used as the method for forming the carbon film. Film forming was achieved by performing sputtering for 70 minutes in an argon atmosphere at 5 Pa, with an amount of input electric power of 1.25 kW, with a target substrate distance of 110 mm and with a substrate temperature of 100°C.

The thickness of the carbon film was measured with a contact needle type surface roughness meter (manufactured by Ulvac, Inc.), and the thickness was 0.5 µm. Furthermore, the film density was measured using an X-ray reflection ratio method, and the film density was 1.8 g/cm³. Furthermore, an attempt was made to perform X-ray diffraction on the carbon film, but no peaks attributable to the crystal structure were clearly shown. Therefore, this carbon film was considered to be non-crystalline.

Subsequently, the crystal seed substrate (seed crystal for silicon carbide single crystal growth) having this carbon film formed thereon was attached to the lower surface of the lid of a graphite crucible using an adhesive.

Next, the body portion of a graphite crucible having an inner diameter of 50 mm and a depth of 95 mm was charged with a raw material silicon carbide powder (#240, manufactured by Showa Denko Kabushiki Kaisha) to a depth of 60 mm.

Subsequently, the lid of the graphite crucible having the seed crystal for silicon carbide single crystal growth attached thereto with an adhesive, was disposed to cover the opening of the body portion of the graphite crucible.

Subsequently, the entirety of this graphite crucible was wrapped with a thermally insulating material made of carbon fiber. Then, the graphite crucible wrapped with the thermally insulating material made of carbon fiber was placed inside a vacuum container in a high frequency heating furnace.

Air inside the vacuum container in the high frequency heating furnace was discharged through a discharge pipe provided in the vacuum container, and thereby the interior of the vacuum container was depressurized to 4x 10⁻³ Pa. Subsequently, argon gas (inert gas) was charged in through an inlet pipe, and thereby the pressure was increased to normal pressure.

Subsequently, the operation of discharging the air inside the reaction container by reducing the pressure again to 4×10⁻³ Pa through the discharge pipe and charging argon gas through the inlet pipe, was repeated, and thereby the inside of the reaction container was brought into having an argon gas atmosphere at a pressure of 9.3×10⁴ Pa.

Subsequently, a high frequency coil was heated by passing an electric current through the coil, and thus the temperature of the graphite crucible was raised. The temperature of the upper part of the graphite crucible was adjusted to 2200°C, and the temperature of the lower part was adjusted to be from 2250°C to 2300°C.

Subsequently, the argon gas was discharged through the discharge pipe, and the growth of a silicon carbide single crystal was carried out in a depressurized state at 7 to 40×10² Pa. The rate of crystal growth at this time was 0.05 mm/h to 0.5 mm/h.

Thereafter, the temperature of the graphite crucible was cooled to normal temperature, and then the silicon carbide single crystal was taken out from the graphite crucible.

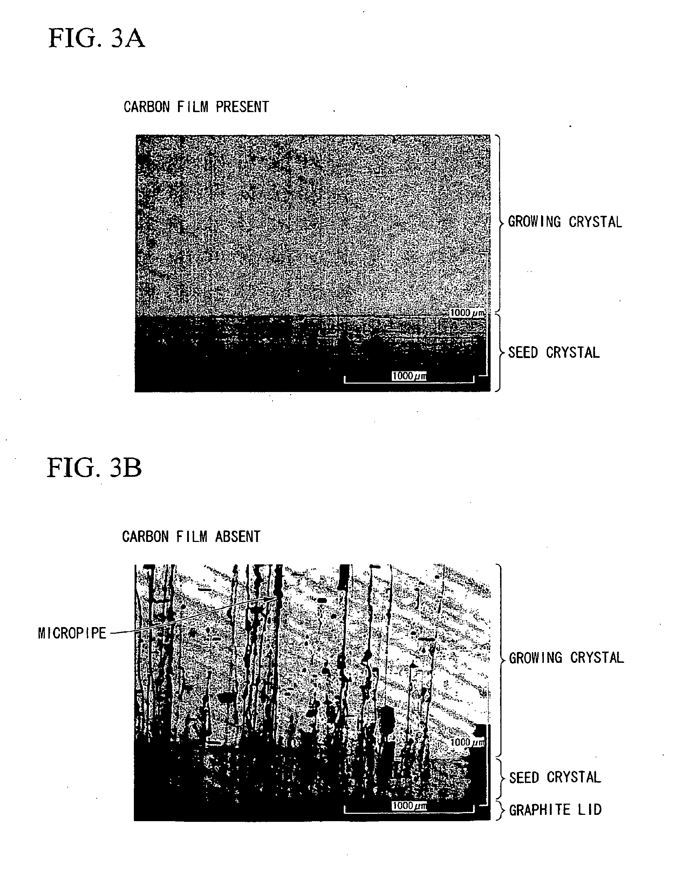

The silicon carbide single crystal thus obtained was cut in parallel with the growth direction, and the cut surface was observed under a microscope. FIG. 3(a) is a microscopic photograph showing the cut surface, which shows the boundary area between the seed crystal and the silicon carbide single crystal. As shown in FIG. 3(a), almost no cavity-like defects were generated in the silicon carbide single crystal.

### (Comparative Example 1)

A silicon carbide single crystal was formed in the same manner as in Example 1, except that a carbon film was not formed on the seed crystal.

The silicon carbide single crystal thus obtained was cut in parallel with the growth direction in the same manner as in Example 1, and the cut surface was observed under a microscope. FIG. 3(b) is a microscopic photograph showing the cut surface, which shows the boundary area between the graphite lid, the seed crystal and the silicon carbide single crystal. As shown in FIG. 3(b), many cavity-like defects were generated in the seed crystal, and a plurality of long-extending in-crystal cavity defects, such as micropipes, was formed in the silicon carbide single crystal. These cavity-like defects and in-crystal cavity defects, such as micropipes, were continuously connected and were growing from the interface between the seed crystal and the graphite lid.

When Example 1 was compared with Comparative Example 1, it was confirmed that cavity-like defects in the seed crystal could be suppressed, and cavity-like defects in the silicon carbide single crystal could be suppressed, by providing the carbon film of the invention at the interface between the seed crystal and the graphite.

### (Example 2)

A silicon carbide single crystal was formed in the same manner in Example 1, except that use was made of a seed crystal for growth formed from a silicon carbide single crystal having a thickness of 0.8 mm in which the (000-1) surface of a 4H-silicon carbide single crystal was defined as a growth surface and the (0001) surface as the surface of the side that was in contact with graphite, and a carbon film was formed on the

### (0001) surface.

The silicon carbide single crystal thus obtained was cut in parallel with the growth direction, and the cut surface was observed under a microscope. Similarly to the case of Example 1, almost no cavity-like defects were generated in the silicon carbide single crystal.

Thereby, it was confirmed that even in the case where the two surfaces of a seed crystal formed of silicon carbide have different polarities, the effect of suppressing defects was exhibited.

### (Example 3)

A silicon carbide single crystal was formed in the same manner as in Example 1, except that a 4H-silicon carbide single crystal was used as a seed crystal, and reverse sputtering was carried out in an Ar atmosphere and at a high frequency electric power of 50 kW, as a pre-sputtering treatment.

The silicon carbide single crystal thus obtained was cut in parallel with the growth direction, and the cut surface was observed under a microscope. Similarly to the case of Example 1, almost no cavity-like defects were generated in the silicon carbide single crystal.

### (Example 4)

A silicon carbide single crystal was formed in the same manner as in Example 1, except that a 4H-silicon carbide crystal was used as a seed crystal, the (0001) surface was defined as the surface of the side that was in contact with graphite, and a carbon film was formed on the (0001) surface using an ion beam method. In addition, the film forming conditions for the carbon film were such that film formation was carried out for one hour using methane as a raw material gas, under an atmosphere at a pressure of 1.3x 10⁻² Pa and an anode voltage of 100 V.

The thickness of the carbon film was 0.4 µm. Furthermore, the film density of the carbon film was measured using an X-ray reflection ration analysis method, and the film density of the carbon film was 2.5 g/cm³. In addition, an attempt was made to perform X-ray diffraction of the carbon film, but peaks attributable to the crystal structure were not clearly shown. Therefore, it was considered that this carbon film was non-crystalline.

The silicon carbide single crystal thus obtained was cut in parallel with the growth direction, and the cut surface was observed under a microscope. Almost no cavity-like defects were generated in the silicon carbide single crystal.

### Industrial Applicability

The invention relates to a seed crystal for silicon carbide single crystal growth, a method for producing the seed crystal, and a method for producing the single crystal. The invention is particularly applicable to industries where high quality silicon carbide single crystals that can be used in optical devices, high pressure-resistant semiconductor elements for high power applications, high electrical power devices, high temperature-resistant elements, radiation-resistant elements, high frequency elements and the like, are produced and utilized.

### Reference Signs List

1: VACUUM CONTAINER
2: THERMALLY INSULATING MATERIAL
3: HEATING COIL
4: SEED CRYSTAL
4a: GROWTH SURFACE
5: RAW MATERIAL SILICON CARBIDE POWDER
6: GRAPHITE CRUCIBLE
7: INLET PIPE
8: DISCHARGE-PIPE
9: RADIATION THERMOMETER
10: PROTRUDED PART
11: ADHESIVE
12: CARBON FILM
12b: BONDING SURFACE
13: SEED CRYSTAL FOR SILICON CARBIDE SINGLE CRYSTAL GROWTH
20: CAVITY PORTION
20b: INNER BOTTOM SURFACE
20a: OPENING
21: BODY PORTION
22: LID
30: SUPPORTING ROD
30C: HOLE

## Claims

1. A seed crystal for silicon carbide single crystal growth, which is attached to a lid of a graphite crucible charged with a raw material silicon carbide powder,
wherein the seed crystal comprises a seed crystal formed of silicon carbide having one surface defined as a growth surface for growing a silicon carbide single crystal by a sublimation method, and a carbon film formed on the surface opposite to the growth surface;
the film density of the carbon film is 1.8 g/cm³ to 2.5 g/cm³; and
the thickness of the carbon film is equal to or greater than 0.1 µm and equal to or less than 20 µm.

2. The seed crystal for silicon carbide single crystal growth according to claim 1, wherein the carbon film is a non-crystalline film.

3. A method for producing a seed crystal for silicon carbide single crystal growth, which is a method for producing the seed crystal for silicon carbide single crystal growth according to claim 1 or 2, the method comprising:
a carbon film forming step of forming a carbon film having a film density of 1.8 g/cm³ to 2.5 g/cm³ by a physical vapor deposition method or a chemical vapor deposition method, on one surface of the seed crystal formed of silicon carbide.

4. The method for producing a seed crystal for silicon carbide single crystal growth according to claim 3, wherein the carbon film is formed by any one of a sputtering method, an ion beam method and a plasma CVD method.

5. The method for producing a seed crystal for silicon carbide single crystal growth according to claim 4, wherein reverse sputtering is carried out before the sputtering method.

6. The method for producing a seed crystal for silicon carbide single crystal growth according to claim 5, wherein the reverse sputtering is carried out using an inert gas with added hydrogen gas or oxygen gas.

7. The method for producing a seed crystal for silicon carbide single crystal growth according to claim 6, wherein the hydrogen gas or the oxygen gas in the inert gas is contained at a concentration of 10% or greater.

8. A method for producing a silicon carbide single crystal, the method comprising:
attaching, with the use of an adhesive, the seed crystal for silicon carbide single crystal growth according to claim 1 or 2, to the lid of a graphite crucible charged with a raw material silicon carbide powder; and
heating the graphite crucible to sublimate the raw material silicon carbide powder and to thereby carry out the crystal growth of a silicon carbide single crystal on the seed crystal for silicon carbide single crystal growth.

## Patentansprüche

1. Keimkristall für das Wachstum eines Siliziumkarbideinkristalls, der an der Abdeckung eines mit Ausgangsmaterial-Siliziumkarbidpulver beladenen Graphitschmelztiegels angebracht ist, wobei der Keimkristall einen Keimkristall enthält, der aus Siliziumkarbid mit einer als Wachstumsoberfläche definierten Oberfläche für das Wachstum eines Siliziumkarbideinkristalls durch ein Sublimierungsverfahren und aus einem auf der Oberfläche gegenüber der Wachstumsoberfläche gebildeten Kohlenstofffilm gebildet ist;
die Filmdichte des Kohlenstofffilms 1,8 g/cm³ bis 2,5 g/cm³ ist; und
die Dicke des Kohlenstofffilms mindestens 0,1 µm und höchstens 20 µm ist.

2. Keimkristall für das Wachstum eines Siliziumkarbideinkristalls nach Anspruch 1, wobei der Kohlenstofffilm ein nichtkristalliner Film ist.

3. Verfahren zum Herstellen eines Keimkristalls für das Wachstum eines Siliziumkarbideinkristalls, welches ein Verfahren zum Herstellen des Keimkristalls für das Wachstum eines Siliziumkarbideinkristalls nach Anspruch 1 oder 2 ist, wobei das Verfahren umfasst:
eine Stufe, in der ein Kohlenstofffilm mit einer Filmdichte von 1,8 g/cm³ bis 2,5 g/cm³ durch ein physikalisches Dampfabscheidungsverfahren oder ein chemisches Dampfabscheidungsverfahren auf einer Oberfläche des aus Siliziumkarbid gebildeten Keimkristalls gebildet wird.

4. Verfahren zum Herstellen eines Keimkristalls für das Wachstum eines Siliziumkarbideinkristalls nach Anspruch 3, wobei der Kohlenstofffilm durch ein Spritzverfahren, Ionenstrahlverfahren oder Plasma CVD Verfahren gebildet wird.

5. Verfahren zum Herstellen eines Keimkristalls für das Wachstum eines Siliziumkarbideinkristalls nach Anspruch 4, wobei vor dem Spritzverfahren ein Umkehrspritzverfahren durchgeführt wird.

6. Verfahren zum Herstellen eines Keimkristalls für das Wachstum eines Siliziumkarbideinkristalls nach Anspruch 5, wobei das Umkehrspritzverfahren unter Verwendung eines Inertgases mit zugegebenem Wasserstoffgas oder Sauerstoffgas durchgeführt wird.

7. Verfahren zum Herstellen eines Keimkristalls für das Wachstum eines Siliziumkarbideinkristalls nach Anspruch 6, wobei das Wasserstoffgas oder das Sauerstoffgas in dem Inertgas in einer Konzentration von 10 % oder höher enthalten ist.

8. Verfahren zum Herstellen eines Siliziumkarbideinkristalls, welches umfasst:
das Anbringen des Keimkristalls für das Wachstum eines Siliziumkarbideinkristalls nach Anspruch 1 oder 2 mit Hilfe eines Klebemittels an die Abdeckung eines mit einem Ausgangsmaterial-Siliziumkarbidpulver beladenen Graphitschmelztiegels; und
das Erhitzen des Graphitschmelztiegels zum Sublimieren des Ausgangsmaterial-Siliziumkarbidpulvers und Durchführen des Kristallwachstums eines Siliziumkarbideinkristalls auf dem Keimkristall für das Wachstum des Siliziumkarbideinkristalls.

## Revendications

1. Cristal de germe pour une croissance de monocristal de carbure de silicium, lequel est fixé à un couvercle d'un creuset en graphite chargé d'une poudre de carbure de silicium de matière première,
dans lequel le cristal de germe comprend un cristal de germe formé de carbure de silicium présentant une surface définie comme une surface de croissance pour faire croître un monocristal de carbure de silicium par un procédé de sublimation, et un film de carbone formé sur la surface opposée à la surface de croissance ;
la densité de film du film de carbone est de 1,8 g/cm³ à 2,5 g/cm³ ; et
l'épaisseur du film de carbone est supérieure ou égale à 0,1 µm et inférieure ou égale à 20 µm.

2. Cristal de germe pour une croissance de monocristal de carbure de silicium selon la revendication 1, dans lequel le film de carbone est un film non cristallin.

3. Procédé de production d'un cristal de germe pour une croissance de monocristal de carbure de silicium, lequel est un procédé de production du cristal de germe pour une croissance de monocristal de carbure de silicium selon la revendication 1 ou 2, le procédé comprenant :
une étape de formation de film de carbone consistant à former un film de carbone présentant une densité de film de 1,8 g/cm³ à 2,5 g/cm³ par un procédé de dépôt physique en phase vapeur ou un procédé de dépôt chimique en phase vapeur, sur une surface du monocristal constitué de carbure de silicium.

4. Procédé de production d'un cristal de germe pour une croissance de monocristal de carbure de silicium selon la revendication 3, dans lequel le film de carbone est formé par l'un quelconque parmi un procédé de pulvérisation cathodique, un procédé à faisceau ionique et un procédé CVD de plasma.

5. Procédé de production d'un cristal de germe pour une croissance de monocristal de carbure de silicium selon la revendication 4, dans lequel une pulvérisation cathodique inverse est réalisée avant le procédé de pulvérisation cathodique.

6. Procédé de production d'un cristal de germe pour une croissance de monocristal de carbure de silicium selon la revendication 5, dans lequel la pulvérisation cathodique inverse est réalisée en utilisant un gaz inerte avec de l'hydrogène gazeux ou de l'oxygène gazeux ajouté.

7. Procédé de production d'un cristal de germe pour une croissance de monocristal de carbure de silicium selon la revendication 6, dans lequel l'hydrogène gazeux ou l'oxygène gazeux dans le gaz inerte est contenu à une concentration de 10 % ou supérieure.

8. Procédé de production d'un monocristal de carbure de silicium, le procédé comprenant :
la fixation, avec l'utilisation d'un adhésif, du cristal de germe pour une croissance de monocristal de carbure de silicium selon la revendication 1 ou 2, au couvercle d'un creuset en graphite chargé d'une poudre de carbure de silicium de matière première ; et
le chauffage du creuset en graphite pour sublimer la poudre de carbure de silicium de matière première et pour réaliser par-là la croissance cristalline d'un monocristal de carbure de silicium sur le cristal de germe pour une croissance de monocristal de carbure de silicium.
